(19) Europäisches Patentamt
European Patent Office
Office européen des brevets

(11) **EP 2 286 450 B1**

(12) **FASCICULE DE BREVET EUROPEEN**

(45) Date de publication et mention
de la délivrance du brevet:
**19.10.2011 Bulletin 2011/42**

(51) Int Cl.:
*H01L 21/8246* (2006.01)    *H01L 27/02* (2006.01)
*H01L 27/112* (2006.01)   *H01L 27/115* (2006.01)
*G11C 16/00* (2006.01)     *G11C 17/00* (2006.01)

(21) Numéro de dépôt: **09757723.3**

(22) Date de dépôt: **12.05.2009**

(86) Numéro de dépôt international:
**PCT/FR2009/050868**

(87) Numéro de publication internationale:
**WO 2009/147347 (10.12.2009 Gazette 2009/50)**

(54) **MEMOIRE A STRUCTURE DU TYPE EEPROM ET A LECTURE SEULE**

SCHREIBGESCHÜTZTER SPEICHER MIT EEPROM-STRUKTUR

READ-ONLY MEMORY WITH EEPROM STRUCTURE

(84) Etats contractants désignés:
**AT BE BG CH CY CZ DE DK EE ES FI FR GB GR
HR HU IE IS IT LI LT LU LV MC MK MT NL NO PL
PT RO SE SI SK TR**

(30) Priorité: **13.05.2008 FR 0853069**

(43) Date de publication de la demande:
**23.02.2011 Bulletin 2011/08**

(73) Titulaire: **ST Microelectronics (Rousset) SAS
13790 Rousset (FR)**

(72) Inventeur: **FORNARA, Pascal
F-83910 Pourrieres (FR)**

(74) Mandataire: **de Beaumont, Michel
1bis, rue Champollion
38000 Grenoble (FR)**

(56) Documents cités:
**EP-A- 0 890 985       US-A- 5 792 697
US-A- 5 898 197        US-A1- 2003 111 684
US-A1- 2007 047 303    US-A1- 2007 262 372**

## Description

Domaine de l'invention

La présente invention concerne de façon générale les circuits intégrés et plus particulièrement le stockage de façon non volatile dans un circuit intégré d'un codage fixé à la fabrication de ce circuit.

Exposé de l'art antérieur

Les mémoires non volatiles effaçables et programmables électriquement ou mémoires EEPROM (Electrically Erasable Programmable Read Only Memory) sont des mémoires fréquemment utilisées dans les circuits intégrés. Les mémoires EEPROM disponibles dans le commerce ont des capacités de stockage standards. Un utilisateur ayant besoin, pour une application particulière, d'une capacité de stockage donnée utilisera de façon générale la mémoire EEPROM standard ayant la capacité de stockage juste supérieure à la capacité de stockage recherchée. De ce fait, une partie de la mémoire EEPROM peut ne pas être utilisée en fonctionnement.

Par ailleurs, dans de nombreux cas, on a besoin de coder de façon définitive à la fabrication du circuit intégré des mots numériques en mémoire ou des états logiques conditionnant le fonctionnement du circuit. Pour ce faire, on utilise généralement une mémoire non volatile à lecture seule ou mémoire de type ROM.

Il serait souhaitable de pouvoir modifier de façon simple et à coût réduit une partie d'une mémoire EEPROM de façon à l'utiliser comme mémoire à lecture seule. Ceci permettrait d'obtenir une mémoire EEPROM dont une partie fonctionnerait de façon classique comme une mémoire non volatile effaçable et programmable électriquement et dont une autre partie fonctionnerait comme une mémoire à lecture seule. On optimiserait ainsi le taux d'utilisation de la mémoire.

Pour les mémoires à lecture seule classiques, le codage s'effectue en interconnectant les drain et source de transistors constituant les cellules mémoire de sorte que l'état lu dans la cellule dépend de la présence de cette connexion. On utilise généralement le premier niveau de métallisation de la structure pour effectuer cette programmation.

Un inconvénient d'une telle programmation est qu'elle se trouve visible par analyse du masque de réalisation du niveau d'interconnexion, par exemple par reconstitution de ce masque à partir d'un circuit (reverse enqineering).

EP 0890985 décrit une mérmoire non volatile comprenant des cellules EEPROM (1) et des cellules ROM (2) à double grille ayant la même structure, les cellules ROM se distinguant des cellules EEPROM par la présence d'une yone dopée (80) entre la source (6') et la drain (7') susceptible de court-circuiter la source et le drain.

US 20072623723 (fig. 8A-10; § 73-81 divulgue une cellule EEPROM où la couche Isolante (33) est plus fine dans sa portion centrale que dans les coins. Il s'agit a diminuer les risques de courant de fuite lorsque l'on réduit l'épaisseur de la couche isolante.

Les documents US 5898197 (fig. 8A-8B; col. 12, I 10-20) et US 2007047303 divanlguent le principe de l'injection de charges par effet tunnel entre deux grilles de mémorisation (respectivement 5, 9 et 114, 118). Il s'agit de permettre la progammation de plusieurs valeurs par cellule.

Résumé de l'invention

La présente invention vise la réalisation d'une mémoire à lecture seule dont la structure est proche de celle d'une mémoire EEPROM et pour laquelle la programmation de l'état logique est invisible par analyse du masque de définition des niveaux d'interconnexion de la structure.

Ainsi, un mode de réalisation de la présente invention prévoit une mémoire non volatile comprenant au moins des première et seconde cellules mémoire, comprenant chacune un transistor MOS à double grille de mémorisation ayant une couche isolante interposée entre les deux grilles. La couche isolante du transistor de mémorisation de la seconde cellule mémoire comprend au moins une portion moins isolante que la couche isolante du transistor de mémorisation de la première cellule mémoire.

Selon un mode de réalisation de la présente invention, la couche isolante du transistor de mémorisation de la première cellule mémoire a une première épaisseur supérieure à 100 nm et ladite portion de la couche isolante du transistor de mémorisation de la seconde cellule mémoire a une seconde épaisseur inférieure à 5 nm.

Selon un mode de réalisation de la présente invention, la couche isolante du transistor de mémorisation de la seconde cellule mémoire comprend une portion supplémentaire à la première épaisseur entourant complètement ladite portion à la seconde épaisseur.

Selon un mode de réalisation de la présente invention, la couche isolante du transistor de mémorisation de la première cellule mémoire à la première épaisseur est constituée d'un empilement d'une première couche d'oxyde de silicium, d'une couche de nitrure de silicium et d'une seconde couche d'oxyde de silicium et la portion à la seconde épaisseur de la couche isolante du transistor de mémorisation de la seconde cellule mémoire est constituée d'une troisième couche d'oxyde de silicium.

Selon un mode de réalisation de la présente invention, le transistor de mémorisation des première et seconde cellules mémoire comprend un empilement d'une première couche isolante, d'une première grille, d'une seconde couche isolante et d'une seconde grille, la seconde couche isolante du transistor de mémorisation de la seconde cellule mémoire comprenant ladite au moins une portion. La mémoire comprend, en outre, un substrat d'un matériau semiconducteur, la première couche isolante recouvrant le substrat et comprenant une première partie isolante moins épaisse qu'une seconde partie isolante.

Un mode de réalisation de la présente invention vise un système électronique comprenant une mémoire telle que définie précédemment et un circuit intégré distinct de la mémoire et relié à la mémoire.

Un mode de réalisation de la présente invention vise un procédé de formation d'une mémoire comprenant au moins des première et seconde cellules mémoire comprenant chacune un transistor MOS à double grille de mémorisation ayant une couche isolante interposée entre les deux grilles. Le procédé consiste à former, dans la couche isolante du transistor de mémorisation de la seconde cellule mémoire, au moins une portion moins isolante que la couche isolante du transistor de mémorisation de la première cellule mémoire.

Selon un mode de réalisation de la présente invention, le procédé comprend, pour chacune des première et seconde cellules mémoire, après une étape de formation d'une première grille du transistor de mémorisation et avant une étape de formation d'une seconde grille du transistor de mémorisation, les étapes successives consistant à former, pour les première et seconde cellules mémoire, sur la première grille, une première couche isolante ; à former, seulement pour la seconde cellule mémoire, une ouverture dans la première couche isolante ; à former, dans ladite ouverture, une seconde couche isolante moins isolante que la première couche isolante.

Selon un mode de réalisation de la présente invention, la première couche isolante est constituée d'un empilement d'une première couche d'oxyde de silicium, d'une couche de nitrure de silicium et d'une seconde couche d'oxyde de silicium, et la seconde couche isolante est constituée d'une troisième couche d'oxyde de silicium.

Un mode de réalisation de la présente invention vise un procédé de lecture de la mémoire définie précédemment, comprenant les étapes successives consistant à injecter, pour chacune des première et seconde cellules mémoire, des charges dans une première grille parmi les deux grilles du transistor de mémorisation, d'où il résulte, pour la première cellule mémoire, un stockage des charges dans la première grille et, pour la seconde cellule mémoire, une évacuation des charges de la première grille vers l'autre des deux grilles ; et à mesurer des données représentatives des charges stockées dans la première grille pour les première et seconde cellules mémoire.

## Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :

la figure 1 est un schéma électrique d'une cellule mémoire EEPROM ;

la figure 2 est un schéma électrique d'une cellule mémoire EEPROM modifiée selon un mode de réalisation de l'invention ;

la figure 3 représente, de façon schématique, une mémoire à lecture seule selon un mode de réalisation de l'invention ;

la figure 4 représente, sous la forme d'un schéma par blocs, les étapes d'un procédé de lecture de la mémoire de la figure 3 selon un mode de réalisation de l'invention ;

la figure 5 représente, de façon schématique, un circuit électronique comprenant une mémoire à lecture seule selon un mode de réalisation de l'invention ;

les figures 6A à 6C illustrent, selon des plans de coupe perpendiculaires, un exemple de réalisation de la structure de la cellule mémoire de la figure 2 ; et

les figures 7A à 7J et 8A à 8J sont des coupes réalisées respectivement selon des plans de coupe perpendiculaires de structures obtenues à des étapes successives d'un exemple de procédé de fabrication de la cellule mémoire représentée aux figures 6A et 6C.

## Description détaillée

De mêmes éléments ont été désignés par de mêmes références aux différentes figures qui ont été tracées sans respect d'échelle. Par souci de clarté, seuls les éléments et étapes utiles à la compréhension de l'invention ont été représentés et seront décrits.

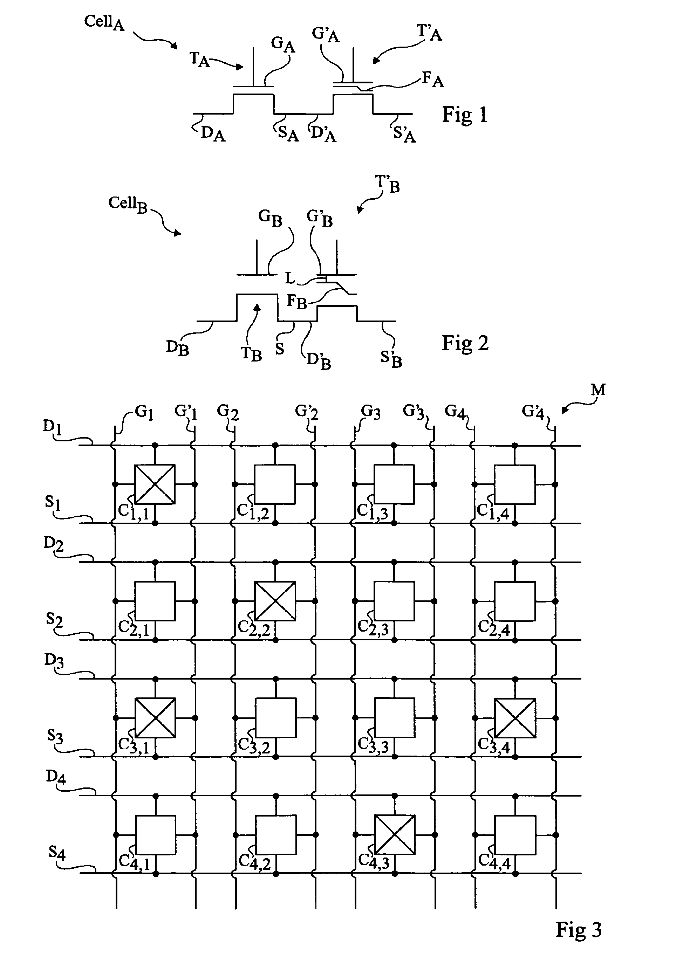

La figure 1 est un schéma électrique d'une cellule mémoire $Cell_A$ constitutive d'une mémoire EEPROM. La cellule mémoire $Cel_lA$ comprend un transistor de sélection $T_A$ et un transistor de mémorisation $T_A'$ ou point mémoire. Le transistor $T_A$ est un transistor MOS comportant un drain $D_A$, une source $S_A$ et une grille isolée $G_A$. Le point mémoire $T_A'$ est un transistor MOS du type à double grille. Il comporte un drain $D_A'$, une source $S_A'$, et deux grilles isolées, à savoir une grille flottante $F_A$ et une grille de commande $G_A'$. On considère ici un point mémoire $T_A'$ dont l'isolant de la grille flottante $F_A$ comporte au moins une partie suffisamment peu isolante, par exemple suffisamment mince, pour permettre un passage, par effet tunnel, de porteurs entre le canal sous-jacent et la grille flottante $F_A$. La partie mince de l'isolant de la grille flottante $F_A$ est appelé "isolant tunnel", "oxyde tunnel" ou "fenêtre tunnel". La source $S_A$ du transistor $T_A$ est reliée au drain $D_A'$ du point mémoire $T_A'$.

Le fonctionnement de la cellule mémoire $Cell_A$ est le suivant. Une opération d'effacement de la cellule mémoire est réalisée en rendant passant le transistor de sélection $T_A$, en mettant à 0 volt le drain $D_A'$ et la source $S_A'$, et en mettant la grille de commande $G_A'$ à un potentiel d'effacement. Ceci entraîne le passage de charges (par exemple d'électrons lorsque la grille $G_A$' est mise à un potentiel d'effacement positif) du drain $D_A$' vers la grille flottante $F_A$ par la fenêtre tunnel et l'accumulation de charges dans la grille flottante $F_A$. Une opération d'écriture dans la cellule mémoire $Cell_A$ est réalisée en rendant passant le transistor de sélection $T_A$, en appliquant une tension d'écriture entre le drain $D_A$' et la source $S_A$' et en maintenant la grille de commande $G_A$' à 0 volt. Ceci entraîne l'évacuation des charges stockées dans la grille flottante $F_A$ par la fenêtre tunnel. Une opération de lecture est réalisée en rendant passant le transistor de sélection $T_A$, en appliquant une tension de lecture, inférieure à la tension d'écriture, entre le drain $D_A$' et la source $S_A$', et en mettant la grille de commande $G_A$' à un potentiel de lecture donné. La tension de seuil du transistor $T_A$' est plus élevée lorsque des charges sont stockées dans la grille flottante $F_A$. L'intensité du courant traversant le point mémoire $T_A$' est alors représentative de la présence ou de l'absence de charges dans la grille flottante $F_A$. A titre d'exemple, on considère que la valeur logique "0" est stockée dans la cellule mémoire $Cell_A$ lorsque des charges sont stockées dans la grille flottante $F_A$ du point mémoire $T_A$' et que la valeur logique "1" est stockée dans la cellule mémoire $Cell_A$ lorsque la grille flottante $F_A$ du point mémoire $T_A$' ne contient pas de charges.

La présente invention vise à modifier certaines cellules d'une mémoire EEPROM de façon que la mémoire EEPROM puisse être utilisée, en totalité ou en partie, comme une mémoire ROM.

La figure 2 représente de façon schématique un exemple de cellule mémoire EEPROM modifiée $Cell_B$. La cellule mémoire $Cell_B$ a la même structure que la cellule EEPROM $Cell_A$ de la figure 1 à la différence que la couche isolante située entre la grille flottante $F_B$ et la grille de commande $G_B$' du transistor de mémorisation $T_B$' ou point mémoire est modifiée de façon à permettre la fuite des charges stockées dans la grille flottante $F_B$ vers la grille de commande $G_B$'. A titre d'exemple, comme cela sera décrit plus en détail par la suite, on prévoit, au niveau de la couche isolante séparant la grille flottante $F_B$ de la grille de commande $G_B$', une portion moins isolante que le reste de la couche isolante de façon à permettre le passage des charges stockées dans la grille flottante $F_B$ vers la grille de commande $G_B$'. Il peut s'agir d'une portion mince d'un matériau isolant. Il peut également s'agir d'une portion d'un matériau conducteur reliant la grille flottante $F_B$ à la grille de commande $G_B$'. Les dimensions de la portion moins isolante sont choisies de sorte que la fuite des charges stockées dans la grille flottante $F_B$ vers la grille de commande $G_B$' soit la plus rapide possible. On a symbolisé par un trait désigné par la référence L le passage des charges entre la grille flottante $F_B$ et la grille de commande $G_B$'.

La figure 3 représente un exemple de réalisation schématique d'une mémoire M pouvant fonctionner comme une mémoire ROM. La mémoire M peut correspondre à une portion d'une mémoire plus importante, non représentée, ayant, par ailleurs la structure d'une mémoire EEPROM classique. La mémoire M comprend des cellules mémoire $C_{i,j}$ disposées en rangées et en colonnes, où i et j sont des entiers variant entre 1 et 4 dans le présent exemple de réalisation. Certaines des cellules mémoire correspondent à une cellule mémoire EEPROM non modifiée, par exemple la cellule $Cell_A$ représentée en figure 1, tandis que d'autres correspondent à une cellule mémoire EEPROM modifiée, par exemple la cellule $Cell_B$ représentée en figure 2. Plus précisément, on prévoit des cellules mémoire non modifiées aux emplacements de la mémoire M où l'on souhaite stocker la valeur logique "0" et on prévoit des cellules mémoire modifiées aux emplacements de la mémoire M où l'on souhaite stocker la valeur logique "1". A titre d'exemple, les cellules $C_{1,1}$, $C_{2,2}$, $C_{3,1}$, $C_{3,4}$ et $C_{4,3}$, indiquées par des croix, sont des cellules EEPROM modifiées et les autres cellules mémoire de la mémoire M sont des cellules EEPROM non modifiées.

A chaque rangée de la mémoire M sont associées deux pistes $D_i$, $S_i$. La piste $D_i$ est reliée aux drains $D_A$, $D_B$ des transistors de sélection $T_A$, $T_B$ des cellules mémoire de la rangée et la piste Si est reliée aux sources $S_A$', $S_B$' des points mémoire $T_A$', $T_B$' des cellules mémoire de la rangée. A chaque colonne sont associées deux pistes $G_i$ et $G'_i$. La piste $G_i$ est reliée aux grilles $G_A$, $G_B$ des transistors de sélection $T_A$, $T_B$ des cellules mémoire de la colonne et la piste $G'_i$ est reliée aux grilles $G_A$', $G_B$' des points mémoire $T_A$', $T_B$' des cellules mémoire de la colonne.

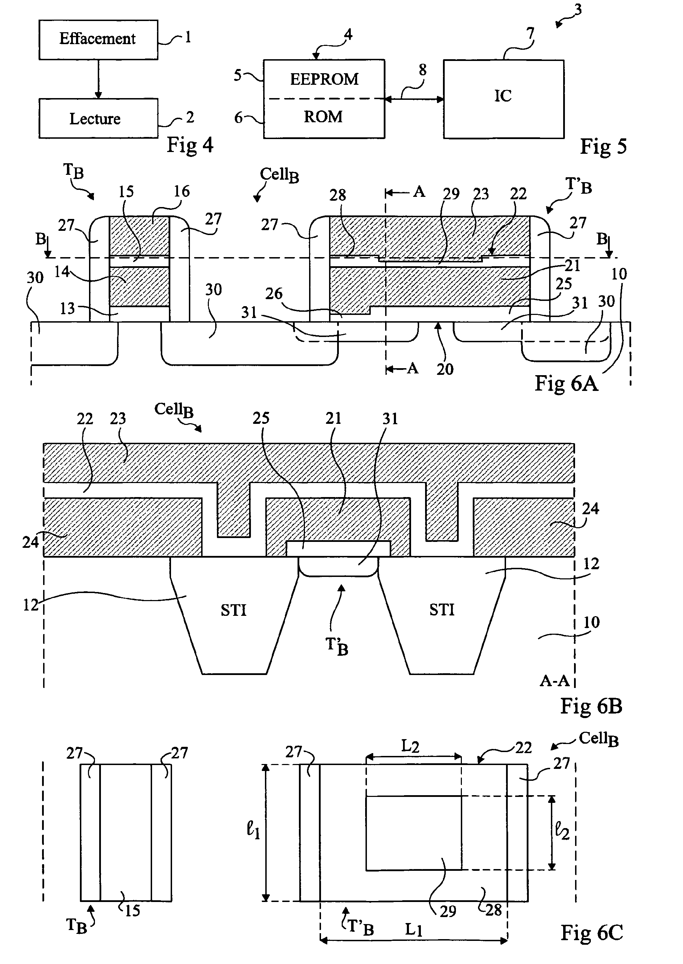

La figure 4 illustre sous la forme d'un schéma par blocs un exemple d'un cycle de lecture de la mémoire M de la figure 3.

Le procédé débute à l'étape 1 à laquelle toutes les cellules mémoire de la mémoire M sont effacées. Pour ce faire, les pistes $G_i$ sont mises à un potentiel d'effacement donné (par exemple positif) pour rendre passant les transistors de sélection des cellules mémoire, les pistes $D_i$ et $S_i$ sont mises à 0 volt et les pistes $G'_i$ sont mises à un potentiel donné. Ceci entraîne, pour chaque cellule mémoire EEPROM modifiée et non modifiée, le passage d'électrons du drain $D_A$', $D_B$' vers la grille flottante $F_A$, $F_B$ du point mémoire $T_A$', $T_B$' de chaque cellule mémoire par la fenêtre tunnel et l'accumulation d'électrons dans la grille flottante $F_A$, $F_B$ du point mémoire $T_A$', $T_B$'. Pour les cellules mémoire EEPROM non modifiées, les électrons restent stockées dans la grille flottante $F_A$ du point mémoire $T_A$'. Pour les cellules mémoire EEPROM modifiées, les charges s'échappent très rapidement de la grille flottante $F_B$ du point mémoire $T_B$' par l'intermédiaire de la portion mince de la couche isolante séparant la grille flottante $F_B$ de la grille de commande $G_B$' du point mémoire $T_B$', de sorte que, très rapidement après l'étape d'effacement, quasiment aucune charge n'est conservée dans la grille flottante $F_B$. La tension de seuil d'un transistor $T_B$' est plus élevée si des charges sont stockées dans la grille flottante $F_B$.

Le procédé se poursuit à l'étape 2 à laquelle une opération de lecture proprement dite des cellules mémoire est réalisée. A titre d'exemple, les états des cellules d'une même rangée peuvent être lus simultanément. La lecture d'une cellule mémoire $C_{i,j}$ est obtenue en mettant à un potentiel de lecture donné la piste $G_i$ pour rendre passant les transistors de sélection $T_A$, $T_B$ des cellules mémoire correspondantes, en appliquant une tension de lecture donnée entre les pistes $D_i$ et $S_i$ et en mettant la piste $G'_i$ à un potentiel donné. L'intensité du courant traversant le transistor $T_A'$, $T_B'$ dépend de la présence ou de l'absence de charges stockées dans la grille flottante $F_A$, $F_B$. Pour toutes les cellules mémoire EEPROM non modifiées, l'étape de lecture va indiquer une valeur logique "0" puisque des électrons sont stockés dans la grille flottante $F_A$ du point mémoire $T_A'$ de la cellule mémoire. Pour les cellules mémoire EEPROM modifiées, l'étape de lecture va indiquer une valeur logique "1" puisqu'il n'y a pas d'électrons stockés dans la grille flottante $F_B$ du point mémoire $T_B'$ de la cellule mémoire.

De ce fait, après chaque cycle de lecture comprenant successivement l'étape d'effacement 1 et l'étape de lecture 2, les valeurs stockées dans la mémoire M sont les suivantes:

$$\begin{pmatrix} 1 & 0 & 0 & 0 \\ 0 & 1 & 0 & 0 \\ 1 & 0 & 0 & 1 \\ 0 & 0 & 1 & 0 \end{pmatrix}$$

Ainsi, la mémoire M peut être considérée comme une mémoire à lecture seule dans la mesure où le cycle de lecture décrit précédemment permet d'obtenir toujours les mêmes valeurs logiques qui ne dépendent que de la structure de la mémoire M. En outre, le cycle de lecture débutant par une opération d'effacement de toutes les cellules de la mémoire, le fonctionnement de la mémoire M n'est pas perturbé par la présence de cellules EEPROM non modifiées qui seraient "défectueuses", c'est-à-dire pour lesquelles la capacité de rétention de charges dans la grille flottante (en nombre de cycle de lecture) serait inférieure à la capacité habituellement requise pour une cellule EEPROM classique. En effet, l'étape d'effacement étant suivie de l'étape de lecture proprement dite, la charge globale stockée à l'étape d'effacement dans une cellule EEPROM classique n'a pas le temps d'évoluer lorsque l'étape de lecture suivante est réalisée même si la cellule est "défectueuse". Le fonctionnement de la mémoire M est donc fiable dans le temps.

Lors de l'étape d'écriture d'une cellule EEPROM d'une mémoire EEPROM classique, l'évacuation des électrons de la grille flottante $F_A$ du transistor $T_A'$ par la fenêtre tunnel s'accompagne d'une injection de trous dans la grille flottante $F_A$ par la fenêtre tunnel. Lorsque les tensions appliquées sont les mêmes, on observe que la tension de seuil d'un transistor $T_A'$ d'une cellule mémoire après une opération d'écriture diminue davantage que la tension de seuil d'un transistor $T_B'$ d'une cellule EEPROM modifiée dont les électrons se sont échappés de la grille flottante $F_B$ vers la grille de commande $G_B'$. De ce fait, lors d'un cycle de lecture de la mémoire M, le potentiel d'effacement appliqué à la grille de commande des transistors peut être supérieur au potentiel d'effacement appliqué lors d'une étape d'effacement d'une mémoire EEPROM classique. Ceci permet de stocker davantage de charges dans la grille flottante des transistors de la mémoire M et d'augmenter la différence de tensions de seuil entre les cellules de la mémoire M dans lesquelles des charges sont stockées et les cellules de la mémoire M dont les charges ont fui par la grille de commande.

La figure 5 représente, de façon schématique, un circuit électronique 3 comprenant une mémoire 4 comportant une portion 5 (EEPROM) correspondant à une mémoire EEPROM et une portion 6 (ROM) correspondant à une mémoire à lecture seule, par exemple la mémoire décrite précédemment en relation avec la figure 3. Le circuit électronique 3 comprend, en outre, un autre circuit intégré 7 (IC), par exemple un circuit d'interface, relié à la mémoire 4 par une liaison 8, par exemple un bus d'échange de données, pour l'écriture de données dans la portion 5 de la mémoire 4 et pour la lecture de données stockées dans les portions 5 ou 6 de la mémoire 4.

La figure 6A est une coupe latérale d'une cellule mémoire $Cell_B$ du type de celle de la figure 2. La figure 6B est une coupe de la figure 6A selon la ligne A-A et la figure 6C est une coupe de la figure 6A selon la ligne B-B.

La cellule $Cell_B$ est formée dans une région active d'un substrat semiconducteur 10, typiquement en silicium monocristallin, délimitée latéralement par des zones d'isolement de champ 12 (STI, figure 6B). Au-dessus du substrat 10 sont formées les structures de grille du transistor $T_B$ et du point mémoire $T_B'$. La grille du transistor $T_B$ est composée d'un empilement d'une première portion isolante 13, d'une première portion conductrice 14, d'une seconde portion isolante 15 et d'une seconde portion conductrice 16. Il peut être souhaitable que le fonctionnement du transistor $T_B$ soit similaire à celui d'un transistor MOS classique à grille unique. Pour ce faire, les portions conductrices 14 et 16 peuvent être court-circuitées par des pistes et des vias métalliques non représentés.

Les grilles du point mémoire $T_B'$ sont constituées d'un empilement d'une première portion isolante 20, d'une première portion conductrice 21, d'une seconde portion isolante 22 et d'une seconde portion conductrice 23. En figures 6B, on a représenté d'autres portions conductrices 24 s'étendant sur le substrat 10 et n'appartenant pas à la cellule mémoire $Cell_B$. La portion conductrice 21 forme la grille flottante du point mémoire $T_B'$. La portion conductrice 23 forme la grille de commande du point mémoire $T_B'$. La portion conductrice 23 peut cor-

responde à une bande conductrice et peut également former la grille de commande d'autres points mémoire. La portion isolante 20 comporte une partie relativement épaisse 25 formant la partie non tunnel de l'isolant de la grille flottante 21 et une partie relativement mince 26 constituant la zone d'oxyde tunnel. La portion d'oxyde 26 plus fine que la portion 25 s'étend sur toute la largeur de la zone active jusqu'au dessus des zones d'isolation de champ 12. Des espaceurs 27 sont formés de part et d'autre du transistor $T_B$ et du point mémoire $T_B$'.

Pour la cellule mémoire EEPROM modifiée Cell$_B$, la portion isolante 22 comporte une partie relativement épaisse 28 et une partie relativement mince 29. La cellule mémoire EEPROM non modifiée Cell$_A$ peut avoir la même structure que celle représentée aux figures 6A à 6C à la différence que la portion isolante 22 a sensiblement une épaisseur constante.

Les portions conductrices 21 et 23 sont, par exemple, en silicium polycristallin et ont une épaisseur, respectivement, d'environ 100 nm et d'environ 200 nm. La portion isolante 20 est en oxyde, par exemple en oxyde de silicium ($SiO_2$). La partie épaisse 28 de la portion isolante 22 comprend, par exemple, un empilement oxyde-de-nitrure-oxyde (empilement "ONO") d'une épaisseur totale d'environ 180 nm. A titre d'exemple, dans l'empilement ONO, l'oxyde peut être de l'oxyde de silicium et le nitrure du nitrure de silicium. La partie fine 29 de la portion isolante 22 correspond, par exemple, à une portion d'oxyde de silicium ayant une épaisseur de quelques nanomètres, par exemple de 2 à 3 nm. De façon générale, la portion épaisse 28 a une épaisseur supérieure à 100 nm et la portion mince 29 a une épaisseur inférieure à 5 nm.

De part et d'autre du transistor $T_B$ et du point mémoire $T_B$', des zones d'implantation 30 de drain et de source du transistor $T_B$ et de drain et de source du point mémoire $T_B$' sont formées dans le substrat de silicium 10 (les régions de source du transistor $T_B$ et de drain du point mémoire $T_B$' se rejoignent). Deux autres zones d'implantation 31 sont formées en surface du substrat 10, et s'étendant en partie en dessous de la portion isolante 25 du point mémoire $T_B$'.

A titre d'exemple, le point mémoire $T_B$' a, dans le plan de coupe B-B, une section sensiblement rectangulaire dont le grand côté $L_1$ est de 840 nm et le petit côté $1_1$ est de 640 nm. La portion amincie 29 est, par exemple, centrée par rapport au point mémoire $T_B$'. Elle a, par exemple, dans le plan de coupe B-B, une section sensiblement rectangulaire dont le grand côté $L_2$ est de 400 nm et le petit côté $1_2$ est de 320 nm.

La présence de la portion 29, moins isolante que la portion 28 prévue habituellement entre les deux grilles d'un point mémoire $T_A$' d'une cellule EEPROM, permet la fuite de charges stockées dans la grille flottante 21. Les dimensions de la portion mince 29 sont choisies de sorte que l'évacuation des charges soit la plus rapide possible. La demanderesse a mis en évidence que, pour les dimensions de la portion mince 29 données précédemment à titre d'exemple, le nombre de charges stockées dans la grille flottante 21 après l'étape d'effacement diminue sensiblement de 90 % en quelques millisecondes.

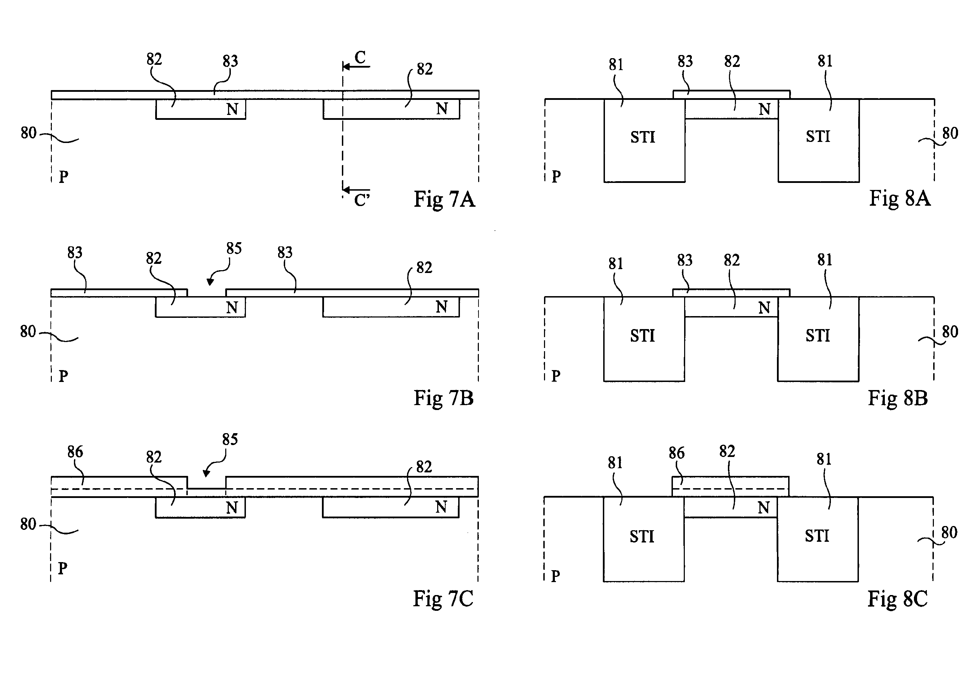

Les figures 7A à 7J sont des coupes latérales de structures obtenues à des étapes successives d'un procédé de fabrication d'une cellule EEPROM modifiée telle que la cellule Cell$_B$ représentée en figure 6A. Les figures 8A à 8J sont des coupes respectivement des figures 7A à 7J selon la ligne C-C (représentée en figure 7A).

Les figures 7A et 8A représentent les structures obtenues après les étapes suivantes:

formation dans un substrat de silicium monocristallin 80 dopé de type P de caissons d'isolation 81 (STI) des cellules mémoire ;
formation de régions 82 dopées de type N, correspondant aux zones 31 de la figure 6A, dans le substrat 80 ; et
formation d'une couche d'oxyde 83 recouvrant l'ensemble du transistor de sélection et du point mémoire. A titre d'exemple, la couche 83 peut être en oxyde de silicium.

Les figures 7B et 8B représentent les structures obtenues après avoir gravé la couche 83 de façon à en éliminer une portion (ouverture 85) au niveau de la zone tunnel du point mémoire. A titre d'exemple, l'ouverture 85 peut être formée par gravure humide.

Les figures 7C et 8C représentent les structures obtenues après avoir formé une couche isolante sur la structure des figures 7B et 8B. Ainsi, la région isolante 86 résultant de cette dernière couche et de la couche 83 sous-jacente comprend une portion d'épaisseur plus faible au niveau de l'ouverture 85. On forme ainsi la couche isolante de la grille flottante du point mémoire et la première couche isolante du transistor de sélection.

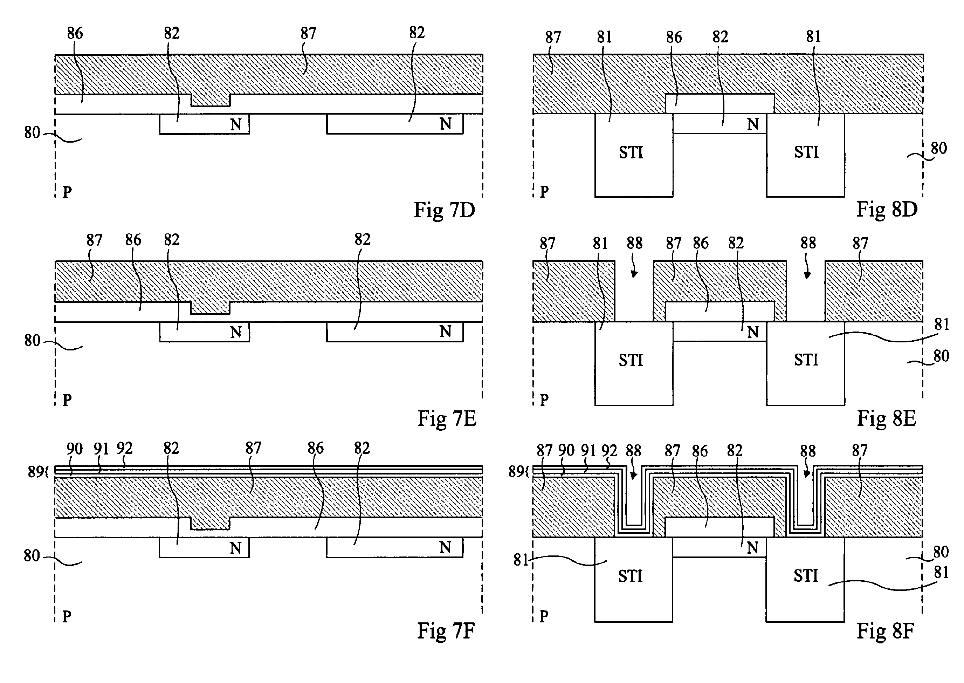

Les figures 7D et 8D représentent les structures obtenues après avoir formé une couche de silicium polycristallin 87 sur l'ensemble de la structure.

Les figures 7E et 8E représentent les structures obtenues après avoir gravé la couche de silicium polycristallin 87 de façon à former des ouvertures 88 séparant la cellule EEPROM de cellules adjacentes. Les ouvertures 88 sont formées au-dessus des caissons d'isolation 81 (STI).

Les figures 7F et 8F représentent les structures obtenues après avoir formé, sur la couche 87 et sur les parois et le fond des ouvertures 88, une couche isolante 89. A titre d'exemple, la couche isolante 89 peut être constituée d'un empilement oxyde-nitrure-oxyde (ONO), par exemple d'une première couche d'oxyde de silicium 90, d'une couche de nitrure de silicium 91 et d'une seconde couche d'oxyde de silicium 92.

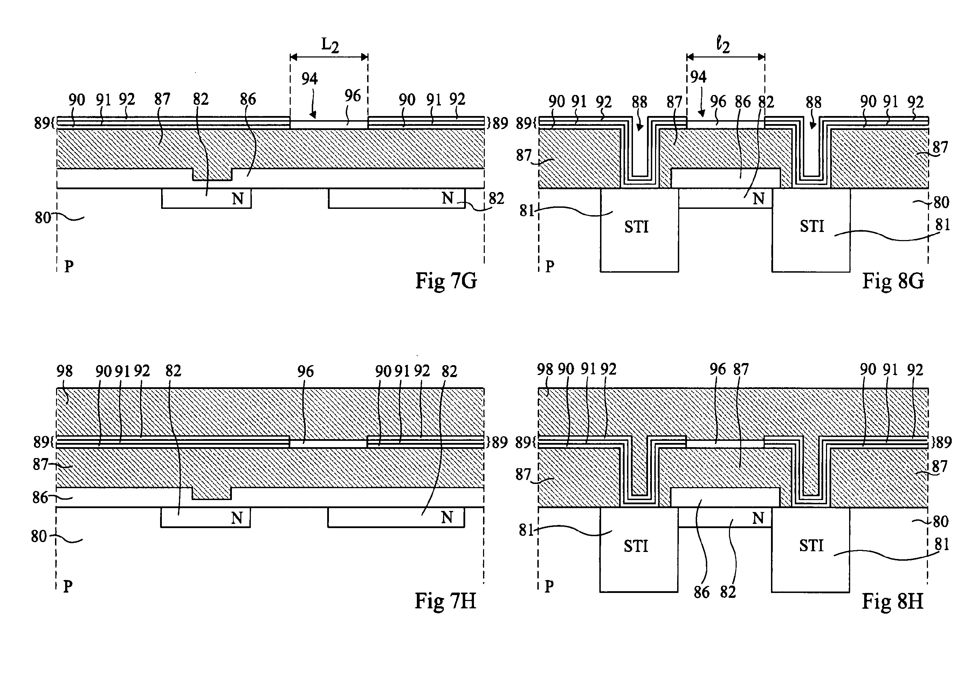

Les figures 7G et 8G représentent les structures obtenues après avoir réalisé une ouverture 94 dans l'empilement ONO (90, 91, 92) et après avoir formé, sur la couche de silicium polycristallin 87 au niveau de l'ouverture 94, une couche isolante 96. A titre d'exemple, l'ouverture 94 peut être obtenue par deux gravures successives: une gravure sèche pour graver la couche d'oxyde 92 et la couche de nitrure 91, puis une gravure humide pour ôter la couche d'oxyde 90. La couche isolante 96 peut être obtenue par oxydation de la couche de silicium polycristallin 87. La portion isolante 96 correspond à la portion mince 29 de la cellule mémoire $Cell_B$ de la figure 6A.

Les figures 7H et 8H représentent les structures obtenues après avoir formé une couche de silicium polycristallin 98 sur la structure des figures 7G et 8G.

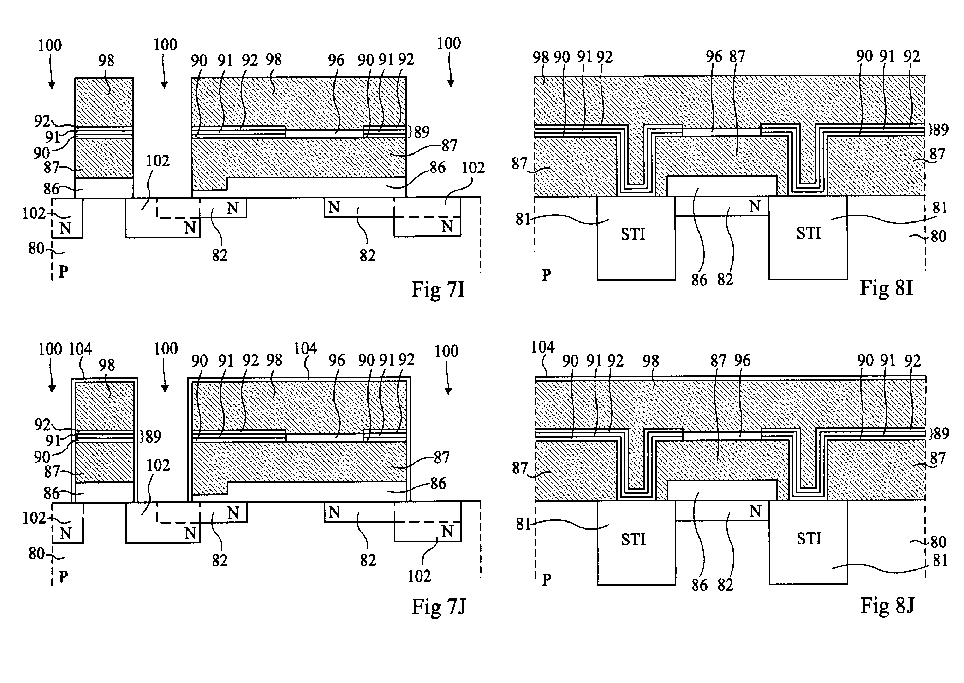

Les figures 7I et 8I représentent les structures obtenues après avoir délimité les grilles du transistor de sélection et du point mémoire et formé les régions de source et de drain du transistor de sélection et du point mémoire. Pour cela, l'ensemble constitué de la couche de silicium polycristallin 98, de l'empilement ONO (90, 91, 92), de la première couche de silicium polycristallin 87 et de la couche isolante 86, est gravé pour former des ouvertures 100. Des régions 102 dopées de type N sont ensuite formées dans le substrat 80, au niveau des ouvertures 100, pour former les sources et les drains du transistor de sélection et du point mémoire.

Les figures 7J et 8J représentent les structures obtenues après avoir formé une fine couche isolante 104, au-dessus et sur les côtés du transistor de sélection et du point mémoire. La couche isolante 104 peut être obtenue par une oxydation thermique. Des espaceurs peuvent ensuite être formés, par tout procédé habituel, de part et d'autre du transistor de sélection et du point mémoire.

Le procédé de formation de cellules mémoire décrit précédemment permet de réaliser simultanément des cellules mémoire EEPROM modifiées et des cellules mémoire EEPROM non modifiées. En effet, il suffit, à l'étape décrite précédemment en relation avec les figures 7G et 8G, de ne former les portions minces 96 que pour les cellules mémoire EEPROM modifiées, la couche isolante 89 n'étant pas gravée pour les cellules mémoire EEPROM non modifiées. Le procédé décrit précédemment peut donc être mis en oeuvre pour réaliser une mémoire comportant une première portion correspondant à une mémoire EEPROM et une seconde portion correspondant à une mémoire à lecture seule.

En outre, par rapport à un procédé de formation habituel de cellules mémoire EEPROM, ce procédé a l'avantage de ne pas nécessiter d'étapes supplémentaires. En effet, habituellement, lorsque l'on forme des cellules mémoires EEPROM, on forme également des transistors MOS basse tension à grille unique sur le même substrat. Les transistors basse tension sont formés sur et dans des régions du substrat au niveau desquelles on élimine la couche de silicium polycristallin 87. L'isolant de grille et la grille des transistors basse tension sont formés, respectivement, par la couche isolante 96 et par la couche 98 de silicium polycristallin. Pour obtenir la structure des figures 6A à 6C, il suffit donc de modifier le masque servant habituellement à enlever l'empilement ONO au niveau des transistors basse tension en lui ajoutant une ouverture au niveau de l'ouverture 94. De plus, la structure des figures 6A à 6C a l'avantage d'être complètement compatible avec les autres cellules en termes de programmation, de lecture et d'écriture.

De façon avantageuse, les dimensions et la position de la portion mince 96 sont choisies de sorte que la portion mince 96 soit complètement entourée par la portion plus épaisse 89. Cela permet, à l'étape décrite précédemment en relation avec les figures 7I et 8I que seul l'empilement 89 épais soit gravé pour toutes les cellules de la mémoire. Ceci permet de ne pas modifier pour cette étape le procédé de fabrication classique d'une mémoire EEPROM. En effet, si pour les cellules EEPROM non modifiées, il fallait graver l'empilement isolant 89 et pour les cellules EEPROM modifiées, il fallait graver la portion mince 96, il faudrait prévoir deux étapes de gravure distinctes étant donné l'épaisseur et la constitution différentes des portions isolantes 89 et 96.

Par rapport à une mémoire ROM classique, les pistes d'interconnexion associées à la mémoire selon le présent exemple de réalisation ne sont pas modifiées pour la programmation. Par conséquent, la programmation de la mémoire selon le présent exemple de réalisation est invisible vue de dessus de la métallisation ou par analyse du masque de réalisation de cette métallisation, ou encore en effectuant des coupes successives pour une reconstitution de ce masque (Delayering).

En outre, on peut prévoir d'ajouter des motifs parasites de façon à empêcher une éventuelle analyse du masque de réalisation des ouvertures 94, par exemple, en prévoyant de telles ouvertures au niveau des tranchées d'isolement STI.

Des modes de réalisation particuliers de la présente invention ont été décrits. Diverses variantes et modifications apparaîtront à l'homme de l'art. En particulier, bien que la présente invention ait été décrite pour une cellule mémoire comprenant un point mémoire et un transistor de sélection, il est clair que la présente invention peut être mise en oeuvre pour tout type de cellule mémoire EEPROM comprenant un transistor à double grille dont une grille est flottante. C'est le cas, par exemple, d'une mémoire Flash pour laquelle, par rapport à la cellule représentée en figure 1, la cellule mémoire peut ne comprendre que le point mémoire $T_A'$.

## Revendications

1. Mémoire non volatile (M) comprenant au moins des première et seconde cellules mémoire ($Cell_A$, $Cell_B$), comprenant chacune un transistor MOS à double grille (21, 23) de mémorisation ($T_A'$, $T_B'$) ayant une couche isolante (22) interposée entre les deux grilles, **caractérisée en ce que** la couche isolante (22) du transistor de mémorisation ($T_B'$) de la seconde cellule mémoire ($Cell_B$) comprend au moins une portion (29) moins isolante que la couche isolante du transistor de mémorisation ($T_A$') de la première cellule mémoire ($Cell_A$).

2. Mémoire (M) selon la revendication 1, dans laquelle la couche isolante du transistor de mémorisation ($T_A$') de la première cellule mémoire ($Cell_A$) a une première épaisseur supérieure à 100 nm et dans laquelle ladite portion (29) de la couche isolante (22) du transistor de mémorisation ($T_B$') de la seconde cellule mémoire ($Cell_B$) a une seconde épaisseur inférieure à 5 nm.

3. Mémoire selon la revendication 2, dans laquelle la couche isolante (22) du transistor de mémorisation ($T_B$') de la seconde cellule mémoire ($Cell_B$) comprend une portion (28) supplémentaire à la première épaisseur entourant complètement ladite portion (29) à la seconde épaisseur.

4. Mémoire selon l'une quelconque des revendications 1 à 3, dans laquelle la couche isolante du transistor de mémorisation ($T_A$') de la première cellule mémoire ($Cell_A$) à la première épaisseur est constituée d'un empilement d'une première couche d'oxyde de silicium (90), d'une couche de nitrure de silicium (91) et d'une seconde couche d'oxyde de silicium (92) et dans laquelle la portion (29) à la seconde épaisseur de la couche isolante (22) du transistor de mémorisation ($T_B$') de la seconde cellule mémoire ($Cell_B$) est constituée d'une troisième couche d'oxyde de silicium (96).

5. Mémoire (M) selon la revendication 1, dans laquelle le transistor de mémorisation ($T_A$', $T_B$') des première et seconde cellules mémoire ($Cell_A$, $Cell_B$) comprend un empilement d'une première couche isolante (20), d'une première grille (21), d'une seconde couche isolante (22) et d'une seconde grille (23), la seconde couche isolante du transistor de mémorisation ($T_B$') de la seconde cellule mémoire ($Cell_B$) comprenant ladite au moins une portion (29), et dans laquelle la mémoire comprend, en outre, un susbtrat (10) d'un matériau semiconducteur, la première couche isolante recouvrant le substrat et comprenant une première partie isolante (26) moins épaisse qu'une seconde partie isolante (25).

6. Système électronique (3) comprenant une mémoire (4) selon la revendication 1 et un circuit intégré (7) distinct de la mémoire et relié à la mémoire.

7. Procédé de formation d'une mémoire (M) comprenant au moins des première et seconde cellules mémoire ($Cell_A$, $Cell_B$) comprenant chacun un transistor MOS à double grille de mémorisation ($T_A$', $T_B$') ayant une couche isolante (22) interposée entre les deux grilles, **caractérisé en ce qu'**il consiste à former, dans la couche isolante (22) du transistor de mémorisation ($T_B$') de la seconde cellule mémoire ($Cell_B$), au moins une portion (29) moins isolante que la couche isolante du transistor de mémorisation ($T_A$') de la première cellule mémoire ($Cell_A$) .

8. Procédé selon la revendication 7, comprenant, pour chacune des première et seconde cellules mémoire ($Cell_A$, $Cell_B$), après une étape de formation d'une première grille (87) du transistor de mémorisation ($T_A$', $T_B$') et avant une étape de formation d'une seconde grille (98) du transistor de mémorisation ($T_A$', $T_B$'), les étapes successives suivantes:

former, pour les première et seconde cellules mémoire, sur la première grille, une première couche isolante (90, 91, 92) ;
former, seulement pour la seconde cellule mémoire ($Cell_B$), une ouverture (94) dans la première couche isolante ;
former, dans ladite ouverture (94), une seconde couche isolante (96) moins isolante que la première couche isolante.

9. Procédé selon la revendication 7, dans lequel la première couche isolante (89) est constituée d'un empilement d'une première couche d'oxyde de silicium (90), d'une couche de nitrure de silicium (91) et d'une seconde couche d'oxyde de silicium (92), et dans lequel la seconde couche isolante (96) est constituée d'une troisième couche d'oxyde de silicium.

10. Procédé de lecture de la mémoire (M) selon l'une quelconque des revendications 1 à 5, comprenant les étapes successives suivantes:

injecter, pour chacune des première et seconde cellules mémoire ($Cell_A$, $Cell_B$), des charges dans une première grille (21) parmi les deux grilles du transistor de mémorisation ($T_A$', $T_B$'), d'où il résulte, pour la première cellule mémoire ($Cell_A$), un stockage des charges dans la première grille et, pour la seconde cellule mémoire ($Cell_B$), une évacuation des charges de la première grille vers l'autre des deux grilles ; et
mesurer des données représentatives des charges stockées dans la première grille pour les première et seconde cellules mémoire.

**Claims**

1. A non-volatile memory (M) comprising at least first and second memory cells ($Cell_A$, $Cell_B$), each comprising a first storage MOS transistor ($T_A$', $T_B$') with a dual gate (21, 23) having an insulating layer (22) interposed between the two gates, **characterized**

**in that** the insulating layer (22) of the storage transistor ($T_B$') of the second memory cell ($Cell_B$) comprises at least one portion (29) which is less insulating than the insulating layer of the storage transistor ($T_A$') of the first memory cell ($Cell_A$).

2. The memory (M) of claim 1, wherein the insulating layer of the storage transistor ($T_A$') of the first memory cell ($Cell_A$) has a first thickness greater than 100 nm and wherein said portion (29) of the insulating layer (22) of the storage transistor ($T_B$') of the second memory cell ($Cell_B$) has a second thickness smaller than 5 nm.

3. The memory of claim 2, wherein the insulating layer (22) of the storage transistor ($T_B$') of the second memory cell ($Cell_B$) comprises an additional portion (28) having the first thickness completely surrounding said portion (29) having the second thickness.

4. The memory of any of claims 1 to 3, wherein the insulating layer of the storage transistor ($T_A$') of the first memory cell ($Cell_A$) having the first thickness is formed of a stacking of a first silicon oxide layer (90), of a silicon nitride layer (91), and of a second silicon oxide layer (92) and wherein the portion (29) having the second thickness of the insulating layer (22) of the storage transistor ($T_B$') of the second memory cell ($Cell_B$) is formed of a third silicon oxide layer (96).

5. The memory (M) of claim 1, wherein the storage transistor ($T_A$', $T_B$') of the first and second memory cells ($Cell_A$, $Cell_B$) comprises a stacking of a first insulating layer (20), of a first gate (21), of a second insulating layer (22), and of a second gate (23), the second insulating layer of the storage transistor ($T_B$') of the second memory cell ($Cell_B$) comprising said at least one portion (29), and wherein the memory further comprises a substrate (10) of a semiconductor material, the first insulating layer covering the substrate and comprising a first insulating portion (26) thinner than a second insulating portion (25).

6. An electronic system (3) comprising the memory (4) of claim 1 and an integrated circuit (7) separate from the memory and connected to the memory.

7. A method for forming a memory (M) comprising at least first and second memory cells ($Cell_A$, $Cell_B$) each comprising a dual-gate MOS storage transistor ($T_A$', $T_B$') having an insulating layer (22) interposed between the two gates, and **characterized in that** it includes the step of forming, in the insulating layer (22) of the storage transistor ($T_B$') of the second memory cell ($Cell_B$), at least one portion (29) which is less insulating than the insulating layer of the storage transistor ($T_A$') of the first memory cell ($Cell_A$).

8. The method of claim 7, comprising, for each of the first and second memory cells ($Cell_A$, $Cell_B$), after a step of forming a first gate (87) of the storage transistor ($T_A$', $T_B$') and before a step of forming a second gate (98) of the storage transistor ($T_A$', $T_B$'), the successive steps of:

   forming, for the first and second memory cells, on the first gate, a first insulating layer (90, 91, 92);
   forming, only for the second memory cell ($Cell_B$), an opening (94) in the first insulating layer;
   forming, in said opening (94), a second insulating layer (96) which is less insulating than the first insulating layer.

9. The method of claim 7, wherein the first insulating layer (89) is formed of a stacking of a first silicon oxide layer (90), of a silicon nitride layer (91), and of a second silicon oxide layer (92), and wherein the second insulating layer (96) is formed of a third silicon oxide layer.

10. A method for reading from the memory (M) of any of claims 1 to 5, comprising the successive steps of:

   injecting, for each of the first and second memory cells ($Cell_A$, $Cell_B$), charges into a first gate (21) from among the two gates of the storage transistor ($T_A$', $T_B$'), which results, for the first memory cell ($Cell_A$), in a storage of the charges in the first gate and, for the second memory cell ($Cell_B$), in an evacuation of the charges from the first gate to the other one of the two gates; and measuring data representative of the charges stored in the first gate for the first and second memory cells.

**Patentansprüche**

1. Ein nichtflüchtiger Speicher (M), der wenigstens eine erste und eine zweite Speicherzelle ($Cell_A$, $Cell_B$) aufweist, wobei jede der Speicherzellen einen ersten MOS Speichertransistor ($T_A$', $T_B$') aufweist, mit einem dualen Gate (21, 23), das eine Isolierschicht (22) zwischen den beiden Gates aufweist, ist **dadurch gekennzeichnet, dass** die Isolierschicht (22) des Speichertransistors ($T_B$') der zweiten Speicherzelle ($Cel1_B$) wenigstens einen Teil (29) aufweist, der weniger isolierend ist, als die Isolierschicht des Speichertransistors ($T_A$') der ersten Speicherzelle ($Cell_A$).

2. Der Speicher (M) nach Anspruch 1, wobei die Isolierschicht des Speichertransistors ($T_A$') der ersten Speicherzelle ($Cell_A$) eine erste Dicke größer als 100 nm aufweist und wobei der Teil (29) der Isolierschicht (22) des Speichertransistors ($T_B$') der zweiten Speicherzelle ($Cell_B$) eine zweite Dicke kleiner als 5 nm aufweist.

3. Der Speicher nach Anspruch 2, wobei die Isolierschicht (22) des Speichertransistors ($T_B$') der zweiten Speicherzelle ($Cell_B$) einen zusätzlichen Teil (28) mit der ersten Dicke aufweist, der den Teil (29) mit der zweiten Dicke vollständig umschließt.

4. Der Speicher nach einem der Ansprüche 1 bis 3, wobei die Isolierschicht des Speichertransistors ($T_A$') der ersten Speicherzelle ($Cell_A$) mit der ersten Dicke aus einem Stapel aus einer ersten Siliziumoxidschicht (90), einer Siliziumnitridschicht (91) und einer zweiten Siliziumoxidschicht (92) gebildet ist und wobei der Teil (29) mit der zweiten Dicke der Isolierschicht (22) des Speichertransistors ($T_B$') der zweiten Speicherzelle ($Cell_B$) aus einer dritten Siliziumoxidschicht (96) gebildet ist.

5. Der Speicher (M) nach Anspruch 1, wobei der Speichertransistor ($T_A$', $T_B$') der ersten und der zweiten Speicherzelle ($Cell_A$, $Cell_B$) einen Stapel einer ersten Isolierschicht (20), eines ersten Gate (21), einer zweiten Isolierschicht (22) und eines zweiten Gate (23) aufweist, wobei die zweite Isolierschicht des Speichertransistors ($T_B$') der zweiten Speicherzelle ($Cell_B$) wenigstens den einen Teil (29) aufweist, und wobei der Speicher ferner ein Substrat (10) eines Halbleitermaterials aufweist, wobei die erste Isolierschicht das Substrat bedeckt und einen ersten Isolierteil (26) aufweist, der dünner als ein zweiter Isolierteil (25) ist.

6. Ein elektronisches System (3), das den Speicher (4) nach Anspruch 1 und einen integrierten Schaltkreis (7), der separat zu dem Speicher angeordnet und mit diesem verbunden ist aufweist.

7. Ein Verfahren zum Ausbilden eines Speichers (M), der wenigstens eine erste und zweite Speicherzelle ($Cell_A$, $Cell_B$) aufweist, die jeweils einen dual-Gate MOS Speichertransistor ($T_A$', $T_B$') mit einer Isolierschicht (22) zwischen den beiden Gates aufweist, und **dadurch gekennzeichnet ist, dass** das Verfahren den Schritt des Ausbildens, in der Isolierschicht (22) des Speichertransistors ($T_B$') der zweiten Speicherzelle ($Cell_B$), von wenigstens einem Teil (29) aufweist, der weniger isolierend ist, als die Isolierschicht des Speichertransistors ($T_A$') der ersten Speicherzelle ($Cell_A$).

8. Das Verfahren nach Anspruch 7, weist ferner für jede der ersten und zweiten Speicherzellen ($Cell_A$, $Cell_B$), nach dem Schritt des Ausbildens eines ersten Gate (87) des Speichertransistors ($T_A$', $T_B$') und vor dem Schritt des Ausbildens eines zweiten Gate (98) des Speichertransistors ($T_A$', $T_B$') die folgenden, nacheinander ausgeführten Schritte auf:

Ausbilden, für die erste und zweite Speicherzelle, einer ersten Isolierschicht (90, 91, 92) auf dem ersten Gate;
Ausbilden, nur für die zweite Speicherzelle ($Cell_B$), einer Öffnung (94) in der ersten Isolierschicht;
Ausbilden, in der Öffnung (94), einer zweiten Isolierschicht (96), die weniger isolierend ist als die erste Isolierschicht.

9. Das Verfahren nach Anspruch 7, wobei die erste Isolierschicht (89) ausgebildet ist aus einem Stapel einer ersten Siliziumoxidschicht (90), einer Siliziumnitridschicht (91) und einer zweiten Siliziumoxidschicht (92) und wobei die zweite Isolierschicht (96) aus einer dritten Siliziumoxidschicht gebildet ist.

10. Ein Verfahren zum Lesen des Speichers (M) nach einem der Ansprüche 1 bis 5, das die folgenden, nacheinander ausgeführten Schritte aufweist:

Injizieren, für jede der ersten und zweiten Speicherzellen ($Cell_A$, $Cell_B$), von Ladungen in ein erstes Gate (21) aus den zwei Gates des Speichertransistors ($T_A$', $T_B$'), das für die erste Speicherzelle ($Cell_A$) in einer Speicherung der Ladungen in dem ersten Gate resultiert und für die zweite Speicherzelle ($Cell_B$) in einem Abtransport der Ladungen von dem ersten Gate zu dem anderen der beiden Gates resultiert; und
Messen von Daten, die repräsentativ für die gespeicherten Ladungen in dem ersten Gate für die erste und zweite Speicherzelle sind.

Fig 1

Fig 2

Fig 3

Effacement — 1

Lecture — 2

**Fig 4**

5 — EEPROM
6 — ROM
8
IC — 7
3
4

**Fig 5**

$T_B$     15     16     27     $Cell_B$     28     A     29     23     22     $T'_B$     27

27     B     14     13     30     30     31     26     31     21     25     31     30     10     20     B

**Fig 6A**

22     23     $Cell_B$     25     21     31

24     24     12     12     STI     $T'_B$     STI     12     10

A-A

**Fig 6B**

27     27     27     $Cell_B$     L2     22     27

$\ell_1$     $\ell_2$

$T_B$     15     $T'_B$     29     28     L1

**Fig 6C**

12

EP 2 286 450 B1

**Fig 7A**

**Fig 7B**

**Fig 7C**

**Fig 8A**

**Fig 8B**

**Fig 8C**

Fig 7D

Fig 8D

Fig 7E

Fig 8E

Fig 7F

Fig 8F

EP 2 286 450 B1

Fig 7G

Fig 8G

Fig 7H

Fig 8H

16

Fig 7I

Fig 8I

Fig 7J

Fig 8J

**EP 2 286 450 B1**

**RÉFÉRENCES CITÉES DANS LA DESCRIPTION**

**Documents brevets cités dans la description**

- EP 0890985 A
- US 20072623723 A
- US 5898197 A
- US 2007047303 A